# EUROPÄISCHE PATENTSCHRIFT

(11) **EP 2 274 749 B1**
(45) Veröffentlichungstag und Bekanntmachung des Hinweises auf die Patenterteilung: **03.08.2011**
(21) Anmeldenummer: 10730707.6
(22) Anmeldetag: 16.06.2010
(51) Int. Cl.: H01C 1/14, H01C 17/22, H01C 17/28

(54) **ELEKTRONISCHES BAUELEMENT UND ENTSPRECHENDES HERSTELLUNGSVERFAHREN**
ELECTRONIC COMPONENT AND CORRESPONDING PRODUCTION METHOD
COMPOSANT ÉLECTRONIQUE ET PROCÉDÉ DE FABRICATION CORRESPONDANT

(30) Priorität: 01.07.2009 DE 102009031408
(43) Veröffentlichungstag der Anmeldung: 19.01.2011
(73) Patentinhaber: Isabellenhütte Heusler GmbH & Co.KG, 35683 Dillenburg (DE)
(72) Erfinder: HETZLER, Ullrich, 35688 Dillenburg-Oberscheld (DE)
(74) Vertreter: Beier, Ralph
(86) Internationale Anmeldenummer: PCT/EP2010/003621
(87) Internationale Veröffentlichungsnummer: WO 2010/121841

(56) Entgegenhaltungen:
- EP-A1- 1 901 314
- EP-A2- 1 492 130
- DE-A1- 2 939 594

## Beschreibung

Die Erfindung betrifft ein elektronisches Bauelement, insbe-sondere einen niederohmigen Strommesswiderstand, ein Strommessmodul und ein Batterie management modul, sowie ein entsprechendes Herstellungsverfahren.

Aus EP 0 605 800 A1 ist ein niederohmiger Strommesswiderstand bekannt, der beispielsweise in einem Kraftfahrzeugbordnetz eingesetzt werden kann, um im Rahmen eines Batteriemanagements den Batteriestrom zu messen. Hierbei wird der zu messende Batteriestrom durch den niederohmigen Strommesswiderstand geleitet, wobei gemäß der bekannten Vierleitertechnik die elektrische Spannung gemessen wird, die über dem Strommesswiderstand abfällt und die nach dem Ohmschen Gesetz dem zu messenden Batteriestrom entspricht. Der Strommesswiderstand besteht hierbei aus zwei plattenförmigen Anschlussteilen aus einem Leitermaterial (z.B. Kupfer) und einem ebenfalls plattenförmigen Widerstandselement aus einem Widerstandsmaterial (z.B. CuMnNi), wobei das Widerstandselement zwischen die beiden Anschlussteile eingesetzt und mit den beiden Anschlussteilen elektronenstrahlverschweißt ist. Zur Einspeisung bzw. Ableitung des zu messenden Batteriestroms offenbart diese Druckschrift Schrauben, die an den beiden Anschlussteilen angebracht sind.

Darüber hinaus sind aus dem Stand der Technik auch andere Bauarten von Anschlusskontakten für derartige niederohmige Strommesswiderstände bekannt, wie beispielsweise außen liegende Lötanschlüsse, innen liegende Lötanschlüsse, AMP-Flachstecker, Einpressmuttern, aufgeschweißte Anschlusskontakte, angelötete Litzen oder aufgelötete Leiterplatten. Diese bekannten Bauarten von Anschlusskontakten für niederohmige Strommesswiderstände sind jedoch eigentlich für andere Anwendungsbereiche vorgesehen und für die Kontaktierung von Strommesswiderständen aufgrund der hohen elektrischen Ströme nicht optimal geeignet. Die vorstehend erwähnten Einpressmuttern kommen zwar der geforderten Montagetechnik bereits sehr nahe und haben einen im Vergleich zu außen liegenden Spannungsmessanschlüssen minimalen Materialverbrauch, jedoch sind derartige Einpressmuttern in der Fertigung teuer und haben den Nachteil, dass in der Einpressmutter entstehende Thermospannungen die Spannungsmessung erheblich verfälschen können.

Aus DE 24 28 791 A1 ist ein Vorwiderstand für Kraftfahrzeuge bekannt, wobei der eigentliche Vorwiderstand mit einem Anschlusselement verbunden ist, in dem sich ein Blechdurchzug mit einem Gewinde befindet. Die elektrische Kontaktierung erfolgt hierbei, indem eine Schraube in das Gewinde des Blechdurchzugs eingeschraubt wird. Diese Druckschrift betrifft also einen völlig anderen Widerstandstyp als die Erfindung.

Ferner ist zum Stand der Technik hinzuweisen auf FR 2 879 751 A1, EP 1 030 185 A2, EP 1 363 131 A1 und DE 433 98 35 A1.

Schließlich ist zum Stand der Technik noch hinzuweisen auf EP 1 492 130 A2, DE 29 39 594 A1 und EP 1 901 314 A1.

Der Erfindung liegt deshalb die Aufgabe zugrunde, einen Strommesswiderstand zu schaffen, bei dem die Anschlusskontakte optimiert sind. Insbesondere ist es wünschenswert, eine elektrische Kontaktierung der Anschlussteile zur Spannungsmessung zu ermöglichen, wobei die Kontaktierung einen geringen Materialverbrauch aufweist, möglichst keine Thermospannungen erzeugt und fertigungstechnisch sowie kostenmäßig optimiert ist.

Diese Aufgabe wird durch ein erfindungsgemäßes elektronisches Bauelement und ein entsprechendes Herstellungsverfahren gemäß den Nebenansprüchen gelöst.

Die Erfindung umfasst die allgemeine technische Lehre, einen Anschlusskontakt in einem elektronischen Bauelement (z.B. einem niederohmigen Strommesswiderstand) durch eine Ausprägung in einem plattenförmigen Teilstück des Bauelements zu bilden. Derartige Ausprägungen sind an sich bereits aus DE 43 39 835 A1 bekannt, jedoch wurden derartige Ausprägungen bisher noch nicht zur Ausbildung von elektrischen Anschlusskontakten verwendet, wie es die Erfindung erstmals vorsieht.

Das erfindungsgemäße elektronische Bauelement weist mindestens ein plattenförmiges Teilstück (z.B. ein Anschlussteil) auf, in dem die Ausprägung für den Anschlusskontakt gebildet wird.

Vorzugsweise enthält die Ausprägung eine Durchgangsbohrung in dem plattenförmigen Teilstück, d.h. einen Durchbruch von einer Seite des plattenförmigen Teilstücks auf die gegenüberliegende Seite des plattenförmigen Teilstücks.

Darüber hinaus weist die Ausprägung bzw. die Durchgangsbohrung in dem plattenförmigen Teilstück vorzugsweise ein Gewinde auf, um eine Befestigungsschraube aufzunehmen, mit der beispielsweise ein Kabelschuh an dem Anschlusskontakt festgeschraubt werden kann. Bei dem Gewinde handelt es sich vorzugsweise um ein Innengewinde, das vorzugsweise mindestens 3, 4, 5 oder mindestens 6 Gewindegänge aufweist, um die Befestigungsschraube sicher aufzunehmen. Weiterhin ist zu dem Gewinde zu erwähnen, dass es sich vorzugsweise um ein metrisches Gewinde handelt im Gegensatz zu einem Gewinde für eine Blechschraube.

In dem bevorzugten Ausführungsbeispiel steht die Ausprägung von dem plattenförmigen Teilstück zu einer Seite hin kragenförmig hervor. Die Ausprägung kann also beispielsweise durch Kragenziehen gemäß DIN 8580 hergestellt werden. Die Erfindung ist jedoch hinsichtlich des verwendeten Umformverfahrens zur Herstellung der Ausprägung nicht auf das Kragenziehen beschränkt, sondern auch mit anderen Umformverfahren realisierbar.

In dem bevorzugten Ausführungsbeispiel der Erfindung weist das Bauelement mehrere (z.B. zwei) Spannungs-Anschlusskontakte auf, die durch eine Ausprägung gebildet werden.

Weiterhin ist zu erwähnen, dass die Erfindung nicht auf bestimmte Typen von elektronischen Bauelementen beschränkt ist. Beispielsweise kann es sich bei dem erfindungsgemäßen elektronischen Bauelement um ein passives, diskretes, lineares und/oder zweipoliges Bauelement handeln. Weiterhin kann das erfindungsgemäße Bauelement zur Oberflächenmontage geeignet sein, so dass es sich um ein SMD-Bauelement (SMD: Surface Mounted Device) handelt. Vorzugsweise handelt es sich bei dem erfindungsgemäßen Bauelement jedoch um einen Widerstand, insbesondere um einen Festwiderstand und speziell um einen niederohmigen Strommesswiderstand.

Der erfindungsgemäße Strommesswiderstand weist vorzugsweise zwei plattenförmige Anschlussteile aus einem niederohmigen Leitermaterial (z.B. Kupfer) auf, wie es an sich auch aus der bereits eingangs erwähnten Druckschrift EP 0 605 800 A1 bekannt ist. Darüber hinaus weist der erfindungsgemäße Strommesswiderstand vorzugsweise auch ein plattenförmiges Widerstandselement auf, das elektrisch zwischen die beiden Anschlussteile geschaltet ist und aus einem niederohmigen Widerstandsmaterial (z.B. CuMnNi) besteht, die einen größeren spezifischen Widerstand aufweist als das Leitermaterial der Anschlussteile. Darüber hinaus verfügt der erfindungsgemäße Strommesswiderstand auch über zwei Anschlusskontakte zur elektrischen Kontaktierung (Stromeinspeisung) der beiden plattenförmigen Anschlussteile und zur Messung der über dem Widerstandselement abfallenden elektrischen Spannung, wobei die beiden Anschlusskontakte für die Spannungsmessung jeweils durch eine Ausprägung in dem jeweiligen plattenförmigen Anschlussteil gebildet werden.

Hierbei ist zu erwähnen, dass der im Rahmen der Erfindung verwendete Begriff eines plattenförmigen Anschlussteils bzw. Widerstandselements allgemein zu verstehen ist und nicht darauf beschränkt ist, dass die Anschlussteile bzw. das Widerstandselement eben sind. Es besteht vielmehr auch die Möglichkeit, dass die plattenförmigen Anschlussteile und/oder das plattenförmige Widerstandselement gebogen sind. Entscheidend ist lediglich, dass die plattenförmigen Anschlussteile bzw. das plattenförmige Widerstandselement aus einem Bandmaterial hergestellt werden können, so dass die Anschlussteile und das Widerstandselement in der Regel relativ dünn in Bezug auf die seitliche Ausdehnung sind und parallele Ober- und Unterseiten aufweisen.

Neben den vorsteherid erwähnten Anschlusskontakten zur Spannungsmessung weist der erfindungsgemäße Strommesswiderstand vorzugsweise auch mindestens zwei Anschlusskontakte zur Einspeisung bzw. Ableitung des zu messenden elektrischen Stroms auf. Beispielsweise können diese Anschlusskontakte für den zu messenden Strom aus kreisförmigen Bohrungen in den beiden Anschlussteilen bestehen, in die Schrauben eingesetzt werden können. Es besteht jedoch alternativ auch die Möglichkeit, dass die Anschlusskontakte für den elektrischen Strom aus den bereits eingangs zum Stand der Technik erwähnten Schrauben bestehen, wie sie in EP 0 605 800 A1 beschrieben sind. Die Erfindung ist jedoch hinsichtlich der Bauart der Anschlusskontakte für den elektrischen Strom nicht auf die beiden vorstehend beschriebenen Beispiele beschränkt, sondern umfasst auch andere Bauarten von Anschlusskontakten.

Bei dem Widerstandsmaterial des niederohmigen Widerstandselements kann es sich beispielsweise um eine Kupfer-Legierung handeln, insbesondere eine Kupfer-Mangan-Legierung, wie beispielsweise CuMn7Sn, CuMn3 oder CuMn12Ni. Es besteht jedoch alternativ auch die Möglichkeit, dass als Widerstandsmaterial eine Kupfer-Nickel-Legierung verwendet wird, wie beispielsweise CuNi15, CuNilO, CuNi6, CuNi44, CuNi2 oder CuNi1. Weiterhin besteht im Rahmen der Erfindung die Möglichkeit, dass das Widerstandsmaterial eine Kupfer-Nickel-Mangan-Legierung ist, wie beispielsweise CuNi23Mn oder CuNi30Mn. Das Widerstandsmaterial kann jedoch auch eine Nickel-Legierung sein, wie beispielsweise eine Nickel-Chrom-Legierung, wie bei-spielsweise NiCr6015, NiCr20A2Si, NiCr8020 oder NiCr3020. Ferner besteht die Möglichkeit, dass es sich bei dem Widerstandsmaterial um eine Nickel-Kupfer-Legierung handelt, wie beispielsweise NiCu30Fe. Ein weiteres Beispiel für ein mögliches Widerstandsmaterial ist Nickel, insbesondere Ni99.2, Ni99.6 oder Ni99.98. Darüber hinaus kann es sich bei dem Widerstandsmaterial auch um eine Nickel-Eisen-Legierung oder einer Eisen-Chrom-Legierung handeln, wie beispielsweise Ni-Fe30 oder Ni99.4Fe bzw. FeCr10Al (Aluchrom). Schließlich kann als Widerstandsmaterial auch Kupfer eingesetzt werden, insbesondere sogenanntes E-Kupfer, das auch als Cu-ETP bezeichnet wird.

Als Leitermaterial für die Anschlussteile wird vorzugsweise Kupfer oder eine Kupferlegierung eingesetzt. Entscheidend für die Verwendung in einem Strommesswiderstand ist jedoch die Tatsache, dass die Anschlussteile aus einem Material mit einer größeren spezifischen Leitfähigkeit bestehen als das Widerstandselement.

Hinsichtlich der Bauweise des erfindungsgemäßen Strommesswiderstands bestehen verschiedene Möglichkeiten.

In einer Variante ist das Widerstandselement zwischen die beiden Anschlussteile eingesetzt, so dass die beiden Anschlussteile mit den gegenüberliegenden Seitenkanten des Widerstandselements verbunden sind. Diese Bauweise ermöglicht eine Fertigung aus einem sogenannten Tri-Band, das aus einem langgestreckten Band aus dem Widerstandsmaterial besteht, das beidseitig mit jeweils einem Band aus dem Leitermaterial verschweißt ist und somit aus drei miteinander verschweißten Bändern besteht.

In einer anderen Variante der Erfindung sind die beiden Anschlussteile dagegen auf derselben Seite des Widerstandselements zueinander beabstandet und mit einer gemeinsamen Seitenkante des Widerstandselements verbunden. Diese Variante ermöglicht die Herstellung aus einem Verbundmaterialband, bei dem lediglich ein Band aus dem Widerstandsmaterial mit einem Band aus dem Leitermaterial verschweißt ist.

Die Erfindung ist nicht auf das vorstehend beschriebene erfindungsgemäße Bauelement als Einzelteil beschränkt. Vielmehr umfasst die Erfindung auch ein Batteriemanagementmodul zur Überwachung einer Batterie, insbesondere in einem Kraftfahrzeugbordnetz. Das erfindungsgemäße Batteriemanagementmodul enthält neben dem vorstehend beschriebenen niederohmigen Strommesswiderstand auch eine elektronische Auswertungseinheit, welche die über dem Strommesswiderstand zwischen den beiden erfindungsgemäß ausgebildeten Spannungsmessanschlüssen abfallende Spannung misst, wobei die Auswertungseinheit mechanisch mit dem Strommesswiderstand verbunden ist.

Beispiele für derartige Batteriemanagementmodule sind aus EP 1 030 185 A2 bekannt, so dass der Inhalt dieser Druckschrift der vorliegenden Beschreibung hinsichtlich des Aufbaus und der Funktionsweise des Batteriemanagementmoduls in vollem Umfang zuzurechnen ist.

Ferner umfasst die Erfindung auch allgemein ein Strommessmodul, das neben dem vorstehend beschriebenen niederohmigen Strommesswiderstand eine elektronische Auswertungseinheit aufweist, welche die über dem Strommesswiderstand zwischen den beiden erfindungsgemäß ausgebildeten Spannungsmessanschlüssen abfallende Spannung misst, wobei die Auswertungseinheit mechanisch mit dem Strommesswiderstand verbunden ist. Derartige Strommessmodule sind vielfältig einsetzbar, beispielsweise in der Solartechnik, der Antriebstechnik oder der Stromversorgungstechnik.

Bei der integrierten elektronischen Auswertungseinheit kann es sich beispielsweise um ein ASIC (Application Specific Integrated Circuit) handeln, wie es beispielsweise aus EP 1 363 131 A1 bekannt ist, so dass auch der Inhalt dieser Druckschrift hinsichtlich des Aufbaus und der Funktionsweise eines ASICs der vorliegenden Beschreibung in vollem Umfang zuzurechnen ist.

Darüber hinaus umfasst die Erfindung auch ein Herstellungsverfahren für ein erfindungsgemäßes elektronisches Bauelement, bei dem ein Anschlusskontakt durch eine Ausprägung in dem plattenförmigen Teilstück gebildet wird.

Bei der Herstellung der Ausprägung wird vorzugsweise auch eine Durchgangsbohrung in dem plattenförmigen Teilstück erzeugt und ein Gewinde auf die Ausprägung aufgebracht, um eine Schraube aufzunehmen.

In dem bevorzugten Ausführungsbeispiel wird die Ausformung der Ausprägung, das Einbringen der Durchgangsbohrung und/oder das Aufbringen der Gewinde in einem einzigen Arbeitsgang von derselben Maschine durchgeführt.

Vorzugsweise wird die Ausprägung durch das als Fließbohren bezeichnete Umformverfahren erzeugt, das an sich aus dem Stand der Technik bekannt ist. Geeignete Werkzeuge zum Fließbohren sind beispielsweise von der deutschen Firma Flowdrill GmbH erhältlich und können in handelsüblichen Stanz-/Biegeautomaten verwendet werden.

Weiterhin ist zu erwähnen, dass das erfindungsgemäße Bauelement vorzugsweise aus einem Verbundmaterialband hergestellt wird, wie es ausführlich in EP 0 605 800 A1 beschrieben ist, so dass der Inhalt dieser Druckschrift hinsichtlich der Herstellung des erfindungsgemäßen Bauelements in vollem Umfang zuzurechnen ist.

Andere vorteilhafte Weiterbildungen sind in den Unteransprüchen gekennzeichnet oder werden nachstehend zusammen mit der Beschreibung der bevorzugten Ausführungsbeispiele der Erfindung anhand der Figuren näher erläutert. Es zeigen:
- Figur 1A: eine Querschnittsansicht eines erfindungsgemäßen Strommesswiderstands,
- Figur 1B: eine Aufsicht auf den Strommesswiderstand gemäß Fi- gur 1A,
- Figur 1C: eine vergrößerte Querschnittsansicht durch die Aus- prägung in dem Strommesswiderstand gemäß den Figu- ren 1A und 1B,
- Figur 2A: eine Aufsicht auf eine mögliche Bauform des Strom- messwiderstands,
- Figur 2B: eine Aufsicht auf eine alternativ mögliche Bauform des Strommesswiderstands,
- Figur 3: eine Querschnittsansicht durch ein Batteriemanage- mentmodul mit dem Strommesswiderstand gemäß den Fi- guren 1A-1C und einem ASIC mit einem A/D-Wandler und einer integrierten Signalverarbeitung,
- Figur 4: ein vereinfachtes Schaltbild zur Veranschaulichung des Einsatzes des Strommessmoduls gemäß Figur 3 in einem Kraftfahrzeugbordnetz,
- Figur 5A: das erfindungsgemäße Herstellungsverfahren in Form eines Flussdiagramms,
- Figur 5B: ein Verbundmaterialband und einen daraus abgetrenn- ten Strommesswiderstand gemäß Figur 5A,
- Figur 6A: eine Variante des erfindungsgemäßen Herstellungs- verfahrens in Form eines Flussdiagramms, sowie
- Figur 6B: ein Verbundmaterialband und einen daraus abgetrenn- ten Strommesswiderstand gemäß Figur 6A und Figur 2.

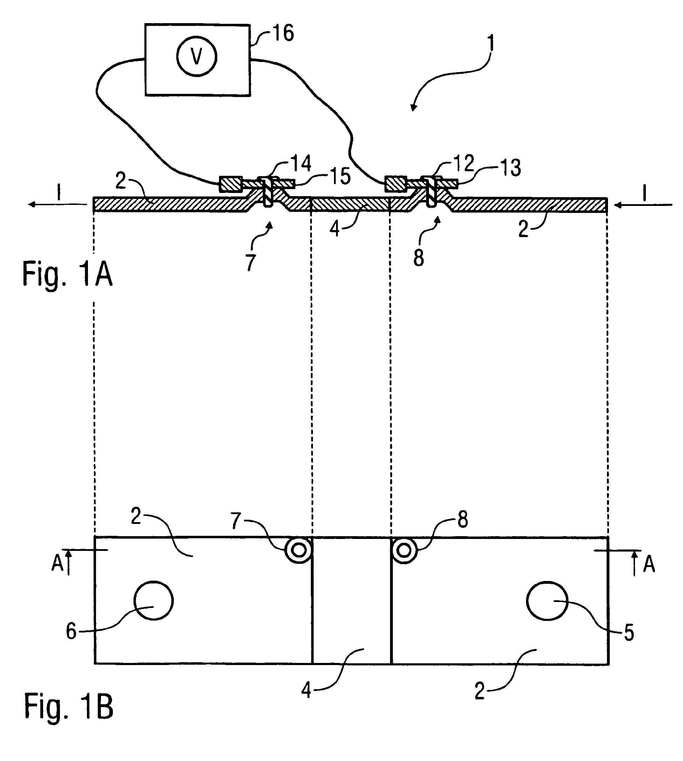

Die Figuren 1A-1C zeigen einen erfindungsgemäßen Strommesswiderstand 1, der beispielsweise in einem Kraftfahrzeugbordnetz eingesetzt werden kann, um einen Batteriestrom I zu messen.

Der Strommesswiderstand 1 besteht im Wesentlichen aus zwei plattenförmigen Anschlussteilen 2, 3 aus Kupfer und einem ebenfalls plattenförmigen Widerstandselement 4 aus einer Kupfer-Mangan-Nickel-Legierung (z.B. Manganin®), wobei das Widerstandselement 4 zwischen die beiden Anschlussteile 2, 3 eingesetzt und mit den beiden Anschlussteilen 2, 3 elektronenstrahlverschweißt ist.

Zur Einspeisung bzw. Ableitung des zu messenden Batteriestroms I weist der Strommesswiderstand 1 zwei herkömmliche Anschlusskontakte 5, 6 auf, die in diesem Ausführungsbeispiel aus jeweils einer kreisförmigen Bohrung in den beiden Anschlussteilen 2, 3 bestehen.

Darüber hinaus weist der Strommesswiderstand 1 zur Spannungsmessung zwei Anschlusskontakte 7, 8 auf, die in neuartiger Weise ausgebildet sind und aus jeweils einer Ausprägung in den plattenförmigen Anschlussteilen 2, 3 bestehen.

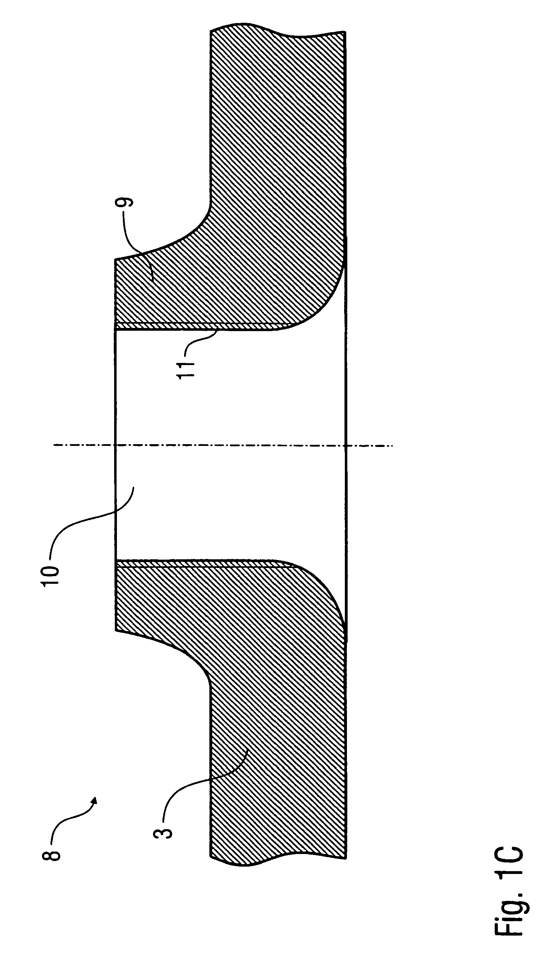

Aus der vergrößerten Querschnittsansicht in Figur 1C ist ersichtlich, dass der Anschlusskontakt 8 einen von dem plattenförmigen Anschlussteil 3 hervorstehenden Kragen 9 aufweist, der eine Durchgangsbohrung 10 umschließt, wobei die Durchgangsbohrung 10 einen Gewindedurchzug mit einem metrischen Innengewinde 11 bildet. In das Innengewinde 11 kann eine Befestigungsschraube 12 eingeschraubt werden, um beispielsweise einen Kabelschuh 13 an dem Anschlusskontakt 8 zu befestigen. In gleicher Weise kann eine Befestigungsschraube 14 an dem Anschlusskontakt 7 festgeschraubt werden, um einen Kabelschuh 15 an dem Anschlusskontakt 7 zu befestigen.

Im Betrieb misst ein hier nur schematisch dargestelltes Spannungsmessgerät 16 die elektrische Spannung, die zwischen den beiden Anschlusskontakten 7, 8 und damit über dem Widerstandselement 4 abfällt, wobei die gemessene elektrische Spannung nach dem Ohmschen Gesetz dem Batteriestrom I proportional ist.

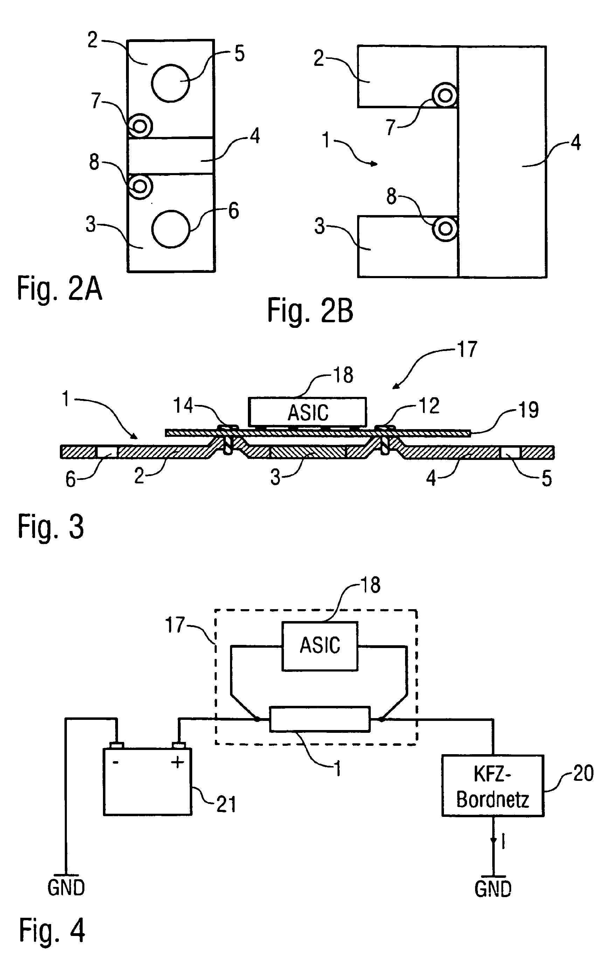

Figur 2B zeigt eine alternativ mögliche Bauart des Strommesswiderstands 1, wobei diese Bauart teilweise mit der vorstehend beschriebenen und in den Figuren 1A-1C dargestellten Bauweise übereinstimmt, so dass zur Vermeidung von Wiederholungen auf die vorstehende Beschreibung verwiesen wird, wobei für entsprechende Einzelheiten dieselben Bezugszeichen verwendet werden.

Eine Besonderheit dieser Variante besteht darin, dass die beiden Anschlussteile 2, 3 auf derselben Seite des Widerstandselements 4 an das Widerstandselement 4 angeschweißt sind.

Figur 3 zeigt ein komplettes Batteriemanagementmodul 17, das im Wesentlichen aus dem Strommesswiderstand 1 gemäß den Figuren 1A-1C und einem ASIC 18 besteht, wobei das ASIC 18 beispielsweise in EP 1 363 131 A1 beschrieben ist und die über dem Widerstandselement 4 des Strommesswiderstands 1 abfallende elektrische Spannung misst. Der ASIC 18 ist mittels einer Leiterplatte 19 mechanisch und elektrisch mit dem Strommesswiderstand 1 verbunden.

Figur 4 zeigt ein vereinfachtes Schaltbild zum Einsatz des Batteriemanagementmoduls 17 gemäß Figur 3 zur Messung des Batteriestroms I in einem Kraftfahrzeugbordnetz 20, das mehrere Verbraucher enthält und von einer Batterie 21 gespeist wird. Zur Vereinfachung ist hierbei der zum Aufladen der Batterie 21 verwendete Generator nicht dargestellt.

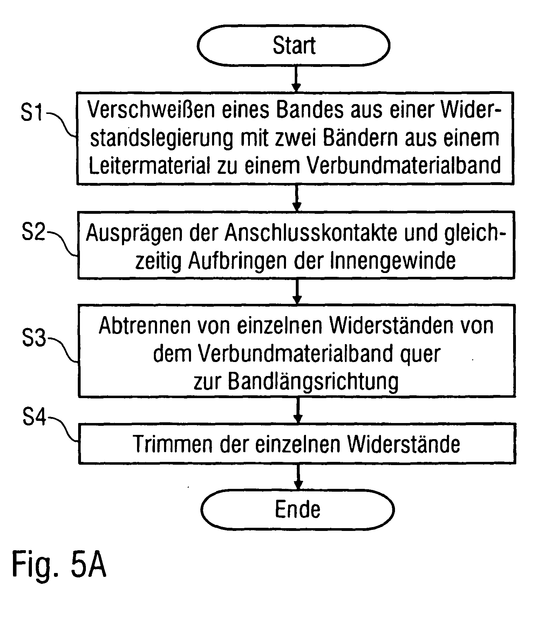

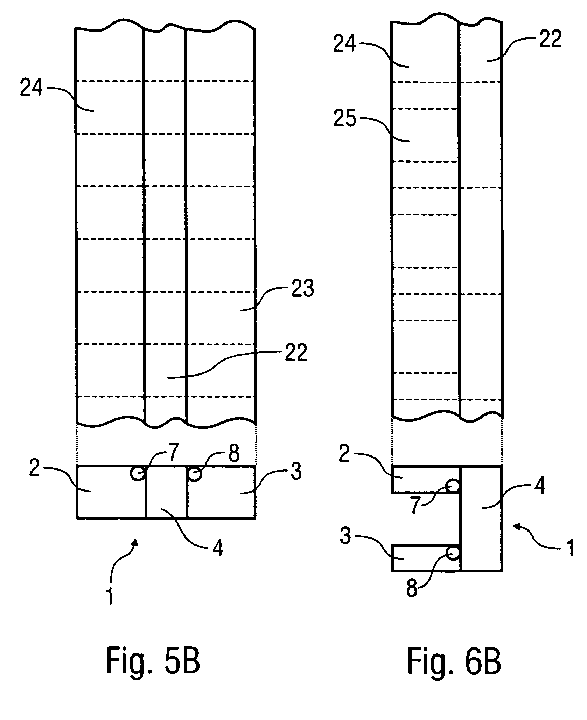

Die Figuren 5A und 5B verdeutlichen die Herstellung des erfindungsgemäßen Strommesswiderstands gemäß den Figuren 1A-1C.

In einem ersten Schritt S1 wird zunächst ein Band 22 beidseitig mit jeweils einem Band 23 bzw. 24 aus dem Widerstandsmaterial elektronenstrahlverschweißt.

Anschließend werden dann in einem weiteren Schritt S2 die Anschlusskontakte 7, 8 ausgeprägt, wobei gleichzeitig das Innengewinde 11 aufgebracht wird.

In einem nächsten Schritt S3 werden dann die einzelnen Strommesswiderstände 1 von dem Verbundmaterial abgetrennt.

Schließlich werden die einzelnen Strommesswiderstände 1 dann in einem Schritt S4 auf den gewünschten Widerstandswert getrimmt.

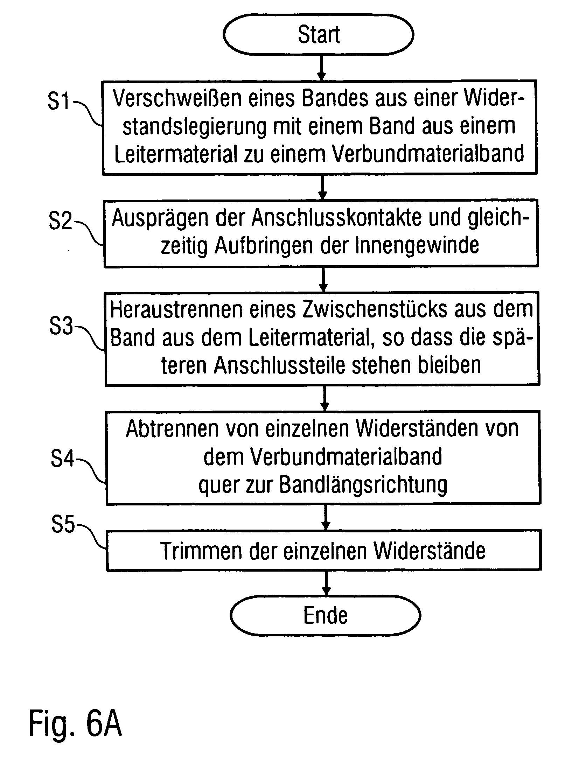

Die Figuren 6A und6B zeigen das Herstellungsverfahren zur Herstellung des Strommesswiderstands 1 gemäß Figur 2.

Hierbei wird zunächst in einem ersten Schritt S1 das Band 22 aus dem Widerstandsmaterial mit dem Band 24 aus dem Leitermaterial elektronenstrahlverschweißt. Im Gegensatz zu dem Herstellungsverfahren gemäß den Figuren 5A und 5B enthält das resultierende Verbundmaterialband hierbei also nur zwei Bänder, die miteinander verschweißt sind.

In einem nächsten Schritt S2 werden dann wieder die Anschlusskontakte 7, 8 ausgeprägt, wobei gleichzeitig wieder das Innengewinde 11 aufgebracht wird.

In einem nächsten Schritt S3 werden dann Zwischenstücke 25 aus dem Verbundmaterialband herausgetrennt, so dass lediglich die späteren Anschlussteile 2, 3 stehen bleiben.

Anschließend werden dann in einem Schritt S4 die einzelnen Strommesswiderstände 1 von dem Verbundmaterialband abgetrennt.

Schließlich erfolgt dann in einem Schritt S5 ein Trimmen der einzelnen Strommesswiderstände.

Die Erfindung ist nicht auf die vorstehend beschriebenen bevorzugten Ausführungsbeispiele beschränkt. Vielmehr ist eine Vielzahl von Varianten und Abwandlungen möglich, die in den Schutzbereich fallen, der durch die unabhängigen Ansprüche definiert ist.

### Bezugszeichenliste:

- 1: Strommesswiderstand
- 2: Anschlussteil
- 3: Anschlussteil
- 4: Widerstandselement
- 5: Anschlusskontakt
- 6: Anschlusskontakt
- 7: Anschlusskontakt
- 8: Anschlusskontakt
- 9: Kragen
- 10: Durchgangsbohrung
- 11: Innengewinde
- 12: Befestigungsschraube
- 13: Kabelschuh
- 14: Befestigungsschraube
- 15: Kabelschuh
- 16: Spannungsmessgerät
- 17: Batteriemanagementmodul
- 18: ASIC
- 19: Leiterplatte
- 20: Kraftfahrzeugbordnetz
- 21: Batterie
- 22: Band aus Widerstandslegierung
- 23: Band aus Leitermaterial
- 24: Band aus Leitermaterial
- 25: Zwischenstücke
- I: Batteriestrom

## Patentansprüche

1. Elektronisches Bauelement (1), insbesondere niederohmiger Strommesswiderstand, mit
a) mindestens einem plattenförmigen Teilstück (2, 3) und
b) mindestens einem Anschlusskontakt (7, 8) zur elektrischen Kontaktierung des plattenförmigen Teilstücks (2, 3),
**dadurch gekennzeichnet,**
c) **dass** der Anschlusskontakt (7, 8) durch eine Ausprägung in dem plattenförmigen Teilstück (2, 3) gebildet ist.

2. Elektronisches Bauelement (1) nach Anspruch 1,
**dadurch gekennzeichnet,**
a) **dass** die Ausprägung eine Durchgangsbohrung (10) in dem plattenförmigen Teilstück (3) enthält, und/oder
b) **dass** die Ausprägung von dem plattenförmigen Teilstück (2, 3) zu einer Seite hin hervorsteht, und/oder
c) **dass** die Ausprägung oder die Durchgangsbohrung (10) ein Gewinde (11) aufweist, um eine Schraube (12, 14) aufzunehmen, und/oder
d) **dass** das Gewinde (11) ein Innengewinde ist, und/oder
e) **dass** das Gewinde (11) mindestens 2, 3, 4, 5 oder mindestens 6 Gewindegänge aufweist.

3. Elektronisches Bauelement (1) nach einem der vorhergehenden Ansprüche in Form eines elektrischen Strommesswiderstands mit
a) zwei plattenförmigen Anschlussteilen (2, 3) aus einem niederohmigen Leitermaterial,
b) einem plattenförmigen Widerstandselement (4), das elektrisch zwischen die beiden Anschlussteile (2, 3) geschaltet ist und aus einem Widerstandsmaterial besteht, das einen größeren spezifischen Widerstand aufweist als das Leitermaterial der Anschlussteile (2, 3), und
c) zwei Anschlusskontakten (7, 8) zur elektrischen Kontaktierung der beiden plattenförmigen Anschlussteile (2, 3) und zur Messung der über dem Widerstandselement (4) abfallenden elektrischen Spannung, wobei die beiden Anschlusskontakte (7, 8) jeweils durch eine Ausprägung in dem jeweiligen plattenförmigen Anschlussteil (2, 3) gebildet werden,
d) zwei Anschlusskontakten (5, 6) an den beiden Anschlussteilen (2, 3) zur Einspeisung bzw. Ableitung eines zu messenden elektrischen Stroms (I).

4. Elektronisches Bauelement (1) nach Anspruch 3, **dadurch gekennzeichnet, dass** das Widerstandsmaterial
a) hochohmig oder niederohmig ist, und/oder
b) eine Kupfer-Legierung ist, insbesondere eine Kupfer-Mangan-Legierung, insbesondere CuMn7Sn, CuMn3, CuMnl2Ni, oder eine Kupfer-Nickel-Legierung, insbesondere CuNi15, CuNi10, CuNi6, CuNi44, CuNi2 oder CuNi1, oder eine Kupfer-Nickel-Mangan-Legierung, insbesondere CuNi23Mn oder CuNi30Mn, oder
c) eine Nickel-Legierung ist, insbesondere eine Nickel-Chrom-Legierung, insbesondere NiCr6015, NiCr20AlSi, NiCr8020 oder NiCr3020, oder eine Nickel-Kupfer-Legierung, insbesondere NiCu30Fe, oder
d) Nickel ist, insbesondere Ni99.2 oder Ni99.6 oder Ni99.98, oder
e) eine Nickel-Eisen-Legierung ist, insbesondere NiFe30 oder Ni99.4Fe, oder
f) eine Eisen-Chrom-Aluminium Legierung, insbesondere FeCr25A15 (Aluchrom) ist.

5. Elektronisches Bauelement (1) nach einem der Ansprüche 3 bis 4, **dadurch gekennzeichnet, dass** das Leitermaterial Kupfer oder eine Kupferlegierung oder Aluminium ist.

6. Elektronisches Bauelement (1) nach einem der Ansprüche 3 bis 5, **dadurch gekennzeichnet,**
a) **dass** das Widerstandselement (4) zwischen die beiden Anschlussteile (2, 3) eingesetzt ist, so dass die beiden Anschlussteile (2, 3) mit gegenüber liegenden Seitenkanten des Widerstandselements (4) verbunden sind, oder
b) **dass** die beiden Anschlussteile (2, 3) auf derselben Seite des Widerstandselements (4) zueinander beabstandet angeordnet und mit einer gemeinsamen Seitenkante des Widerstandselements (4) verbunden sind.

7. Elektronisches Bauelement (1) nach einem der vorhergehenden Ansprüche, **dadurch gekennzeichnet, dass** das Bauelement (1)
a) ein passives und/oder
b) ein diskretes und/oder
c) ein lineares und/oder
d) ein zweipoliges Bauelement (1) und/oder
e) ein SMD-Bauelement (1) und/oder
f) ein Widerstand ist, insbesondere ein Festwiderstand und/oder ein niederohmiger Strommesswiderstand.

8. Strommessmodul (17) zur Überwachung eines Stromes mit
a) einem Strommesswiderstand (1) nach einem der vorhergehenden Ansprüche, wobei der Strommesswiderstand (1) im Betrieb mit dem Verbraucher in Reihe geschaltet ist und den Verbrauchsstrom (I) misst, und
b) einer elektronischen Auswertungseinheit (18), insbesondere einer integrierten Schaltung, welche die elektrische Spannung misst, die über dem Strommesswiderstand (1) zwischen den beiden Anschlusskontakten (7, 8) abfällt, wobei die Auswertungseinheit (18) mechanisch mit dem Strommesswiderstand (1) verbunden ist.

9. Batteriemanagementmodul (17) zur Überwachung einer Batterie (21), insbesondere in einem Kraftfahrzeug, mit einem Strommessmodul nach Anspruch 8.

10. Herstellungsverfahren für ein elektronisches Bauelement (1), insbesondere nach einem der vorhergehenden Ansprüche, mit den folgenden Schritten:
a) Bereitstellung mindestens eines plattenförmigen Teilstücks (2, 3) des Bauelements,
b) Formen eines Anschlusskontaktes (7, 8) an dem plattenförmigen Teilstück (2, 3) zur elektrischen Kontaktierung des plattenförmigen Teilstücks (2, 3),
**dadurch gekennzeichnet,**
c) **dass** der Anschlusskontakt (7, 8) durch eine Ausprägung in dem plattenförmigen Teilstück (2, 3) gebildet wird.

11. Herstellungsverfahren nach Anspruch 10, **gekennzeichnet durch** folgende zusätzliche Schritte:
a) Erzeugen einer Durchgangsbohrung (10) in dem plattenförmigen Teilstück (2, 3) bei der Ausprägung des Anschlusskontaktes (7, 8), und/oder
b) Aufbringen eines Gewindes (11) in die Ausprägung oder die Durchgangsbohrung (10), um eine Schraube (12, 14) aufzunehmen.

12. Herstellungsverfahren nach Anspruch 11,
**dadurch gekennzeichnet,**
a) **dass** die Ausprägung (7, 8), die Durchgangsbohrung (10) und/oder das Gewinde (11) in einem einzigen Arbeitsgang von derselben Maschine erzeugt werden, und/oder
b) **dass** die Ausprägung durch Kragenziehen hergestellt wird.

13. Herstellungsverfahren nach Anspruch 11,
**dadurch gekennzeichnet,**
a) **dass** das Gewinde (11) ein Innengewinde ist, und/oder
b) **dass** das Gewinde (11) mindestens 2, 3, 4, 5 oder mindestens 6 Gewindegänge aufweist.

14. Herstellungsverfahren nach einem der Ansprüche 10 bis 13, **gekennzeichnet durch** folgende Schritte:
a) Bereitstellung eines Widerstands (1) mit zwei plattenförmigen Anschlussteilen (2, 3) aus einem Leitermaterial und einem plattenförmigen Widerstandselement (4) aus einem Widerstandsmaterial, wobei das Widerstandselement (4) elektrisch zwischen die Anschlussteile (2, 3) geschaltet und elektrisch und mechanisch mit den Anschlussteilen (2, 3) verbunden ist,
b) Ausprägen von jeweils einem Anschlusskontakt (7, 8) in den beiden plattenförmigen Anschlussteilen (2, 3) zur elektrischen Kontaktierung der plattenförmigen Anschlussteile (2, 3).

15. Herstellungsverfahren nach Anspruch 14, **gekennzeichnet durch** folgende Schritte zur Bereitstellung des Widerstands (1) :
a) Bereitstellung eines langgestreckten Bandes (22) aus dem Widerstandsmaterial,
b) Bereitstellung von mindestens einem langgestreckten Band (23, 24) aus dem Leitermaterial,
c) Verschweißen des Bandes (22) aus dem Widerstandsmaterial mit dem Band (23, 24) aus dem Leitermaterial in Bandlängsrichtung, so dass ein Verbundmaterialband entsteht,
d) Abtrennen des Widerstands (1) von dem Verbundmaterialband quer zur Bandlängsrichtung.

16. Herstellungsverfahren nach Anspruch 15,
**dadurch gekennzeichnet,**
a) **dass** das Band (22) aus dem Widerstandsmaterial an seinen beiden Längskanten mit jeweils einem Band (23, 24) aus dem Leitermaterial zu dem Verbundmaterialband verschweißt wird, oder
b) **dass** das Band (22) aus dem Widerstandsmaterial mit einem einzigen Band (24) aus dem Leitermaterial zu dem Verbundmaterialband verschweißt wird.

## Claims

1. Electronic component (1), particularly low-ohmic current sense resistor, having
a) at least one plate-shaped part (2, 3) and
b) at least one connecting contact (7, 8) for electrically
contacting the plate-shaped part (2, 3),
**characterized in**
c) **that** the connecting contact (7, 8) is formed by a forming in the plate-shaped part (2, 3).

2. Electronic component (1) according to claim 1, **characterized in**
a) **that** the forming includes a through hole (10) in the plate-shaped part (3), and/or
b) **that** the forming protrudes from the plate-shaped part (2, 3) to one side, and/or
c) **that** the forming or the through hole (10) comprises a thread (11) for receiving a screw (12, 14), and/or
d) **that** the thread (11) is an internal thread, and/or
e) **that** the thread (11) comprises at least 2, 3, 4, 5 or at least 6 thread turns.

3. Electronic component (1) according to one of the preceding claims in the form of an electric current sense resistor having
a) two plate-shaped connector parts (2, 3) made of a low-ohmic conductor material,
b) a plate-shaped resistor element (4) which is electrically inserted between the two connector parts (2, 3) and which consists of a resistor material having a greater specific resistivity than the conductor material of the connector parts (2, 3), and
c) two connecting contacts (7, 8) for electrically contacting the two plate-shaped connector parts (2, 3) and for measuring the electric voltage over the resistor element (4), wherein the two connecting contacts (7, 8) are each formed by a forming in the respective plate-shaped connector part (2, 3),
d) two connector contacts (5, 6) on both connector parts (2, 3) for supplying and discharging, respectively, an electric current (I) to be measured.

4. Electronic component (1) according to claim 3, **characterized in that** the resistor material is
a) high-ohmic or low-ohmic, and/or
b) a copper alloy, particularly a copper-manganese-alloy, particularly CuMn7Sn, CuMn3, CuMn12Ni, or a copper-nickel-alloy, particularly CuNi15 CuNi10 CuNi6, CuNi44, CuNi2 or CuNi1, or a copper-nickel-manganese-alloy, particularly CuNi23Mn or CuNi30Mn, or
c) a nickel-alloy, particularly a nickel-chrome-alloy, particularly NiCr6015, NiCr20AlSi, NiCr8020 or NiCr3020, or a nickel-copper-alloy, particularly NiCu30Fe, or
d) nickel, particularly Ni99.2 or Ni99.6 or Ni99.98, or
e) a nickel-iron-alloy, particularly NiFe30 or Ni99.4Fe,
or
f) an iron-chrome-aluminium-alloy, particularly FeCr25A15 (aluchrome).

5. Electronic component (1) according to one of claims 3 to 4, **characterized in that** the conductor material is copper or a copper alloy or aluminium.

6. Electronic component (1) according to one of claims 3 to 5, **characterized in**
a) **that** the resistor element (4) is inserted between the two connector parts (2, 3), so that the connector parts (2, 3) are connected to opposing side edges of the resistor element (4), or
b) **that** the two connector parts (2, 3) are arranged on the same side of the resistor element (4) in a spaced relationship to each other and are connected to the same side edge of the resistor element (4).

7. Electronic component (1) according to one of the preceding claims, **characterized in that** the component (1) is
a) a passive and/or
b) a discrete and/or
c) a linear and/or
d) a bipolar component (1) and/or
e) an SMD component (1) and/or
f) a resistor, particularly a fixed resistor and/or a low-ohmic current sense resistor.

8. Current sense module (17) for monitoring a current having
a) a current sense resistor (1) according to one of the preceding claims, wherein the current sense resistor (1) is, when in operation, connected in series with the load and measures the load current (I), and
b) an electronic evaluation unit (18), particularly an integrated circuit, which measures the electric voltage over the current sense resistor (1) between the connecting contacts (7, 8), wherein the evaluation unit (18) is mechanically connected to the current sense resistor (1).

9. Battery management module (17) for monitoring a battery (21), particularly in a motor vehicle, having a current sense module according to claim 8.

10. Manufacturing method for an electronic component (1), particularly according to one of the preceding claims, comprising the following steps:
a) providing at least one plate-shaped part (2, 3) of the component,
b) forming of a connecting contact (7, 8) on the plate-shaped part (2, 3) for electrically contacting the plate-shaped part (2,3),
**characterized in**
c) **that** the connecting contact (7, 8) is formed by a forming in the plate-shaped part (2, 3).

11. Manufacturing method according to claim 10, **characterized by** the following additional steps:
a) creating a through-hole (10) in the plate-shaped part (2, 3) during forming of the connecting contact (7, 8), and/or
b) applying a thread (11) in the forming or in the through-hole (10) for receiving a screw (12, 14).

12. Manufacturing method according to claim 11, **characterized in**
a) **that** the forming (7, 8), the through-hole (10) and/or the thread (11) are fabricated in a single operating cycle by the same machine, and/or
b) **that** the forming is manufactured by collar forming.

13. Manufacturing method according to claim 11, **characterized in**
a) **that** the thread (11) is an internal thread, and/or
b) **that** the thread (11) comprises at least 2, 3, 4, 5 or at least 6 thread turns.

14. Manufacturing method according to one of claims 10 to 13, **characterized by** the following steps:
a) providing a resistor (1) having two plate-shaped connector parts (2, 3) made of a conductor material and a plate-shaped resistor element (4) made of a resistor material, wherein the resistor element (4) is electrically inserted between the connector parts (2, 3) and electrically and mechanically connected to the connector parts (2, 3),
b) forming of at least one connecting contact (7, 8) in both plate-shaped connector parts (2, 3) for electrically contacting the plate-shaped connector parts (2, 3).

15. Manufacturing method according to claim 14, **characterized by** the following steps for providing the resistor (1) :
a) providing an elongated band (22) made of a resistor material,
b) providing of at least one elongated band (23,24) made of a conductor material,
c) welding the band (22) made of the resistor material to the band (23, 24) made of the conductor material along a longitudinal direction of the band so that a composite material band is generated,
d) separating the resistor (1) from the composite material band transverse to the longitudinal direction of the band.

16. Manufacturing method according to claim 15, **characterized in**
a) **that** the band (22) made of the resistor material is welded to a band (23, 24) made of the conductor material on each of its longitudinal edges resulting in the composite material band, or
b) **that** the band (22) made of the resistor material is welded with a single band (24) made of the conductor material to the composite material band.

## Revendications

1. Composant électronique (1), en particulier résistance de mesure de courant à basse impédance, comportant
a) au moins un élément en forme de plaque (2, 3) et
b) au moins un contact de connexion (7, 8) pour la mise en contact électrique de l'élément en forme de plaque (2, 3), **caractérisé**
c) **en ce que** le contact de connexion (7, 8) est formé par un relief estampé dans l'élément en forme de plaque (2, 3).

2. Composant électronique (1) selon la revendication 1, **caractérisé**
a) **en ce que** le relief estampé comprend un trou débouchant (10) dans l'élément en forme de plaque (3), et/ou
b) **en ce que** le relief estampé dépasse sur un côté de l'élément en forme de plaque (2, 3), et/ou
c) **en ce que** le relief estampé ou le trou débouchant (10) comporte un filet (11) destiné à recevoir une vis (12, 14), et/ou
d) **en ce que** le filet (11) est un filet femelle, et/ou
e) **en ce que** le filet (11) comprend au moins 2, 3, 4, 5 pas de filet, ou au moins 6 pas de filet.

3. Composant électronique (1) selon l'une des revendications précédentes sous la forme d'une résistance de mesure de courant électrique comportant
a) deux pièces de connexion en forme de plaque (2, 3) en matériau conducteur de basse impédance,
b) un élément de résistance en forme de plaque (4), monté électriquement entre les deux pièces de connexion (2, 3) et composé d'un matériau pour résistance qui présente une résistance spécifique supérieure à celle du matériau conducteur des pièces de connexion (2, 3), et
c) deux contacts de connexion (7, 8) pour la mise en contact électrique des deux pièces de connexion en forme de plaque (2, 3) et pour la mesure de la chute de tension électrique par l'élément de résistance (4), les deux contacts de connexion (7, 8) étant respectivement formés par un relief estampé dans la pièce de connexion (2, 3) correspondante,
d) deux contacts de connexion (5, 6) sur les deux pièces de connexion (2, 3) pour l'alimentation ou la dérivation d'un courant électrique (I) à mesurer.

4. Composant électronique (1) selon la revendication 3, **caractérisé en ce que** le matériau pour résistance
a) est de haute ou de basse impédance, et/ou
b) est un alliage de cuivre, en particulier un alliage cuivre-manganèse, en particulier CuMn7Sn, CuMn3, CuMn12Ni, ou un alliage cuivre-nickel, en particulier CuNi15, CuNi10, CuNi6, CuNi44, CuNi2 ou CuNi1, ou un alliage cuivre-nickel-manganèse, en particulier CuNi23Mn ou CuNi30Mn, ou
c) est un alliage de nickel, en particulier un alliage nickel-chrome, en particulier NiCr6015, NiCr20AlSi, NiCr8020 ou NiCr3020, ou un alliage nickel-cuivre, en particulier NiCu30Fe, ou
d) est du nickel, en particulier Ni99.2 ou Ni99.6 ou Ni99.98, ou
e) est un alliage nickel-fer, en particulier NiFe30 ou Ni99.4Fe, ou
f) est un alliage fer-chrome-aluminium, en particulier FeCr25A15 (aluchrome).

5. Composant électronique (1) selon l'une des revendications 3 ou 4, **caractérisé en ce que** le matériau conducteur est du cuivre, un alliage de cuivre ou de l'aluminium.

6. Composant électronique (1) selon l'une des revendications 3 à 5, **caractérisé**
a) **en ce que** l'élément de résistance (4) est mis en place entre les deux pièces de connexion (2, 3) de manière à relier les deux pièces de connexion (2, 3) par des bords latéraux opposés de l'élément de résistance (4), ou
b) **en ce que** les deux pièces de connexion (2, 3) sont disposées à intervalle l'une de l'autre sur le même côté de l'élément de résistance (4) et sont reliées par un bord latéral commun de l'élément de résistance (4).

7. Composant électronique (1) selon l'une des revendications précédentes, **caractérisé en ce que** ledit composant (1)
a) est un composant (1) passif et/ou
b) un composant (1) discret et/ou
c) un composant (1) linéaire et/ou
d) un composant (1) bipolaire et/ou
e) un composant (1) SMD et/ou
f) une résistance, en particulier une résistance fixe et/ou une résistance de mesure à basse impédance.

8. Module de mesure de courant (17) pour la surveillance d'un courant, comportant
a) une résistance de mesure de courant (1) selon l'une des revendications précédentes, ladite résistance de mesure de courant (1) étant en service montée en ligne avec le récepteur et mesurant le courant consommé (I), et
b) une unité d'analyse électronique (18), en particulier un circuit intégré mesurant la chute de tension électrique par la résistance de mesure de courant (1) entre les deux contacts de connexion (7, 8), ladite unité d'analyse électronique (18) étant mécaniquement raccordée à la résistance de mesure de courant (1).

9. Module gestionnaire de batterie (17) pour la surveillance d'une batterie (21), en particulier dans un véhicule automobile, comportant un module de mesure de courant selon la revendication 8.

10. Procédé de fabrication pour un composant électronique (1), en particulier selon l'une des revendications précédentes, comprenant les étapes suivantes :
a) préparation d'au moins un élément en forme de plaque (2, 3) du composant,
b) formage d'un contact de connexion (7, 8) sur l'élément en forme de plaque (2, 3) pour la mise en contact électrique de l'élément en forme de plaque (2, 3),
**caractérisé**
c) **en ce que** le contact de connexion (7, 8) est formé par un relief estampé dans l'élément en forme de plaque (2, 3).

11. Procédé de fabrication selon la revendication 10, **caractérisé par** les étapes additionnelles suivantes :
a) réalisation d'un trou débouchant (10) dans l'élément en forme de plaque (2, 3) lors de l'estampage du contact de connexion (7, 8), et/ou
b) application d'un filet (11) dans le relief estampé ou le trou débouchant (10), pour la réception d'une vis (12, 14).

12. Procédé de fabrication selon la revendication 11, **caractérisé**
a) **en ce que** le relief estampé (7, 8), le trou débouchant (10) et/ou le filet (11) sont réalisés en une seule passe de travail de la même machine, et/ou
b) **en ce que** le relief estampé est réalisé par emboutissage de collerette.

13. Procédé de fabrication selon la revendication 11, **caractérisé**
a) **en ce que** le filet (11) est un filet femelle, et/ou
b) **en ce que** le filet (11) comprend au moins 2, 3, 4, 5 pas de filet, ou au moins 6 pas de filet.

14. Procédé de fabrication selon l'une des revendications 10 à 13, **caractérisé par** les étapes suivantes :
a) préparation d'une résistance (1) comportant deux pièces de connexion en forme de plaque (2, 3) en matériau conducteur et un élément de résistance en forme de plaque (4) en matériau pour résistance, l'élément de résistance (4) étant monté électriquement entre les pièces de connexion (2, 3), et électriquement et mécaniquement raccordé aux pièces de connexion (2, 3),
b) estampage d'un contact de connexion (7, 8) dans chacune des deux pièces de connexion en forme de plaque (2, 3) pour la mise en contact électrique des pièces de connexion en forme de plaque (2, 3).

15. Procédé de fabrication selon la revendication 14, **caractérisé par** les étapes de préparation de la résistance suivantes (1) :
a) préparation d'une bande allongée (22) constituée du matériau pour résistance,
b) préparation d'au moins une bande allongée (23, 24) constituée du matériau conducteur,
c) soudage de la bande (22) constituée du matériau pour résistance avec la bande (23, 24) constituée du matériau conducteur dans la direction longitudinale de bande, de manière à former une bande en matériau composite,
d) séparation de la résistance (1) de la bande en matériau composite, transversalement à la direction longitudinale de bande.

16. Procédé de fabrication selon la revendication 15, **caractérisé**
a) **en ce que** la bande (22) constituée du matériau pour résistance est soudée sur chacun de ses deux bords longitudinaux avec une bande (23, 24) constituée du matériau conducteur pour former la bande en matériau composite, ou
b) **en ce que** la bande (22) constituée du matériau pour résistance est soudée avec une seule bande (24) constituée du matériau conducteur pour former la bande en matériau composite.
